(19) Europäisches Patentamt
European Patent Office
Office européen des brevets

(11) EP 2 081 222 A1

(12) EUROPEAN PATENT APPLICATION
published in accordance with Art. 153(4) EPC

(43) Date of publication:
**22.07.2009 Bulletin 2009/30**

(21) Application number: **07830824.4**

(22) Date of filing: **30.10.2007**

(51) Int Cl.:
***H01L 21/60*** *(2006.01)* ***H01B 1/00*** *(2006.01)*
***H01B 1/22*** *(2006.01)* ***H01B 5/16*** *(2006.01)*
***H05K 1/14*** *(2006.01)*

(86) International application number:
**PCT/JP2007/071090**

(87) International publication number:
**WO 2008/053873 (08.05.2008 Gazette 2008/19)**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **31.10.2006 JP 2006295789**
**29.10.2007 JP 2007280782**

(71) Applicant: **Hitachi Chemical Company, Ltd.**
**Tokyo 163-0449 (JP)**

(72) Inventors:
- **KOJIMA, Kazuyoshi**
**Chikusei-shi**
**Ibaraki 308-8524 (JP)**
- **KOBAYASHI, Kouji**
**Chikusei-shi**
**Ibaraki 308-8524 (JP)**
- **ARIFUKU, Motohiro**
**Chikusei-shi**
**Ibaraki 308-8524 (JP)**
- **MOCHIZUKI, Nichiomi**
**Chikusei-shi**
**Ibaraki 308-8524 (JP)**

(74) Representative: **Jönsson, Hans-Peter**
**Patentanwälte von Kreisler Selting Werner**
**Deichmannhaus am Dom**
**Bahnhofsvorplatz 1**
**50667 Köln (DE)**

# (54) CIRCUIT CONNECTION STRUCTURE

(57) There is provided a circuit connection structure that can provide satisfactory electrical connection between opposing circuit electrodes and that can sufficiently increase the long-term reliability of electrical characteristics between circuit electrodes. A circuit connection structure 1 comprising a first circuit member 30 having a first circuit electrode 32 formed on the main side 31a of a first circuit board 31, a second circuit member 40 situated opposing the first circuit member 30 and having a second circuit electrode 42 formed on the main side 41a of a second circuit board 41, and a circuit-connecting member 10 provided between the main side of the first circuit member 30 and the main side of the second circuit member 40 and electrically connecting the first and second circuit electrodes 32, 42, **characterized in that** the thickness of the first and second circuit electrodes 32, 42 is at least 50 nm, the circuit-connecting member 10 is obtained by curing a circuit-connecting material containing an adhesive composition and conductive particles 12 having multiple protrusions 14 on the surface side, and the outermost layer of the conductive particles 12 is composed of nickel or a nickel alloy.

***Fig.1***

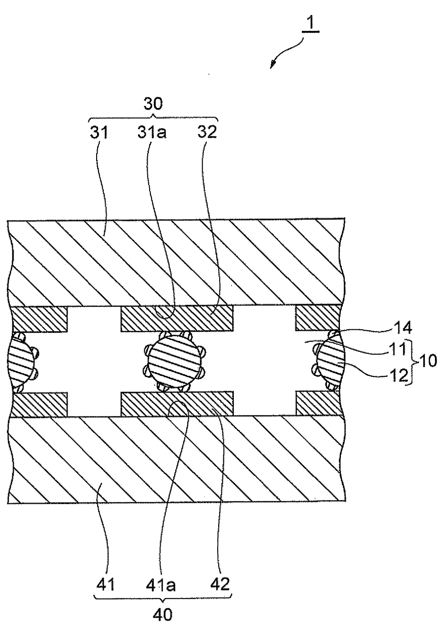


EP 2 081 222 A1

## Description

### Technical Field

The present invention relates to a circuit connection structure.

### Background Art

Circuit-connecting materials comprising conductive particles dispersed in an adhesive (anisotropic conductive adhesives) are used for connection between circuit members, including connection between liquid crystal displays and Tape Carrier Packages (TCP), connection between Flexible Printed Circuits (FPC) and TCPs, and connection between FPCs and printed circuit boards. Recently, "flip-chip mounting" has been used for mounting of semiconductor silicon chips on boards, wherein semiconductor silicon chips are directly mounted face-down onto boards without using wire bonding for connection between circuit members. Circuit-connecting materials such as anisotropic conductive adhesives are used for connection between circuit members in such flip-chip mounting as well (for example, see Patent documents 1-5).
[Patent document 1] Japanese Unexamined Patent Publication SHO No. 59-120436
[Patent document 2] Japanese Unexamined Patent Publication SHO No. 60-191228
[Patent document 3] Japanese Unexamined Patent Publication HEI No. 1-251787
[Patent document 4] Japanese Unexamined Patent Publication HEI No. 7-90237
[Patent document 5] Japanese Unexamined Patent Publication No. 2001-189171
[Patent document 6] Japanese Unexamined Patent Publication No. 2005-166438

### Disclosure of the Invention

<u>Problems to be Solved by the Invention</u>

Incidentally, the recent trend toward decreasing sizes and thicknesses of electronic devices has led to higher density of circuits formed in circuit members, and extremely narrow spacings between adjacent electrodes and widths of the electrodes themselves. Formation of circuit electrodes is accomplished by a process in which the metal material for the circuit is formed over the entire surface of the board, a resist is coated onto the sections where the circuit electrodes are to be formed and is cured, and the other sections are etched with an acid or base; however, with the high-density circuits mentioned above, the etching time differs between hills and valleys if the irregularities in the metal formed over the entire surface of the board are large, thus making it impossible to accomplish fine etching and leading to problems such as shorting between adjust circuits or wire breakage. Consequently, minimal irregularities on the electrode surfaces of high-density circuits, i.e. flat electrode surfaces, are preferred.

However, when mutually opposing flat circuit electrodes are connected using the conventional circuit-connecting materials mentioned above, the adhesive resin remains between the flat electrodes and the conductive particles that are in the circuit-connecting material, making it impossible to ensure long-term reliability and sufficient electrical connection between the opposing circuit electrodes. In order to overcome these problems, therefore, there has been proposed connection between opposing circuit electrodes using a circuit-connecting material that can exhibit a storage elastic modulus and mean thermal expansion coefficient within specified ranges, and having conductive particles of gold (Au) in an outermost layer comprising multiple protrusions on the surface side (Patent document 6).

A circuit connection structure connected using this circuit-connecting material guarantees sufficient electrical connection and long-term reliability between opposing circuit electrodes, but a demand still exists for even more satisfactory electrical connection between opposing circuit electrodes and further increased long-term reliability of electrical characteristics between circuit electrodes.

The present invention has been accomplished in light of the problems of the prior art described above, and its object is to provide a circuit connection structure that provides satisfactory electrical connection between opposing circuit electrodes as well as sufficiently increased long-term reliability of electrical characteristics between circuit electrodes.

<u>Means for Solving the Problems</u>

As a result of much diligent research conducted with the aim of solving the aforementioned problems, the present inventors have found that those problems can be attributed particularly to the material of the outermost layer of the conductive particles in the circuit-connecting material forming the circuit-connecting member, and to the thickness of the circuit electrodes of the circuit connection structure. Specifically, the outermost layer of the conductive particles in a circuit-connecting material is conventionally a metal film of Au, and because Au is a relatively soft metal, the outermost

layer of the conductive particles becomes deformed against the circuit electrodes so that the conductive particles do not readily become embedded in the circuit electrodes even though the adhesive composition between the conductive particles and flat electrodes is penetrated at the protrusions during circuit connection. Also, if the thickness of the opposing circuit electrodes is too small, the protrusions on the conductive particle surface in the circuit-connecting material during contact bonding of the circuit-connecting member can potentially penetrate the circuit electrodes to contact the circuit board, thus reducing the contact area between the circuit electrodes and conductive particles and increasing connection resistance. The present inventors have further found, as a result of further diligent research toward the solving the aforementioned problems, that they can be solved by changing the material of the outermost layer of the conductive particles to a harder metal than Au and by restricting the thickness of the opposing circuit electrodes to above a fixed value, and the invention has been completed upon this finding.

Specifically, the circuit connection structure of the invention is a circuit connection structure comprising a first circuit member having a first circuit electrode formed on the main side of a first circuit board, a second circuit member situated opposing the first circuit member and having a second circuit electrode formed on the main side of a second circuit board, and a circuit-connecting member provided between the main side of the first circuit member and the main side of the second circuit member and electrically connecting the first and second circuit electrodes, **characterized in that** the thickness of the first and second circuit electrodes is at least 50 nm, the circuit-connecting member is obtained by curing a circuit-connecting material containing an adhesive composition and conductive particles having multiple protrusions on the surface side, and the outermost layer of the conductive particles is composed of nickel or a nickel alloy.

According to this circuit connection structure, it is possible to form more satisfactory electrical connection between opposing first and second circuit electrodes via conductive particles while also further increasing the long-term reliability of electrical characteristics between circuit electrodes, compared to structures wherein the outermost layer of the conductive particles is Au and the thickness of at least one of the first and second circuit electrodes is less than 50 nm. That is, even though the cured adhesive composition is incorporated between the conductive particles and the first or second circuit electrode, the multiple protrusions formed on the surface side of the conductive particles causes the pressure applied by the conductive particles onto the cured adhesive composition to be sufficiently larger than conductive particles without protrusions, so that the protrusions of the conductive particles easily penetrate the cured adhesive composition, while they also permeate to some extent in the circuit electrodes, thus increasing the contact area between the conductive particles and circuit electrodes. Moreover, nickel (Ni) or nickel alloys used as the outermost layer of conductive particles are harder than Au, and therefore the outermost layer of the conductive particles permeates more easily into the first and second circuit electrodes, thus allowing the contact area between the conductive particles and circuit electrode to be increased and consequently resulting in more satisfactory long-term reliability of electrical connection and electrical characteristics. In addition, if the thickness of the first and second circuit electrodes is at least 50 nm, the protrusions of the conductive particles will penetrate further into the first or second circuit electrode, thus helping to prevent reduction in contact area. It is thereby possible to obtain satisfactory electrical connection between circuit electrodes. The satisfactory electrical connection between the first and second circuit electrodes via the conductive particles is also maintained for prolonged periods by the cured adhesive composition, thus allowing sufficient increase in the long-term reliability of the electrical characteristics.

In the circuit connection structure described above, at least the outermost layer of the first or second circuit electrode preferably contains indium-tin oxide (ITO) or indium-zinc oxide (IZO). It is advantageous for the circuit electrodes to have an outermost layer composed of ITO or IZO, in order to prevent oxidation of the ground layer metal, as compared to electrodes with outermost layers composed of metals such as Au, Ag, Sn or Pt, or Al, Cr or the like.

In the circuit connection structure described above, the heights of the protrusions of the conductive particles are preferably 50-500 nm and the distance between adjacent protrusions is preferably no greater than 1000 nm. If the heights of the protrusions of the conductive particles and the distance between adjacent protrusions are within these ranges, it will be possible for the protrusions of the conductive particles to penetrate the cured adhesive composition more easily, so that more satisfactory electrical connection and long-term reliability of electrical characteristics can be obtained.

Effect of the Invention

The circuit connection structure of the invention can provide satisfactory electrical connection between opposing circuit electrodes as well as sufficiently increased long-term reliability of electrical characteristics between circuit electrodes.

**Brief Description of the Drawings**

Fig. 1 is a cross-sectional view showing an embodiment of a circuit connection structure according to the invention.

Fig. 2(a) is a cross-sectional view showing an example of a conductive particle in the circuit-connecting member of a circuit connection structure according to the invention, and (b) is a cross-sectional view showing another example of a conductive particle in the circuit-connecting member of a circuit connection structure according to the invention.

Explanation of Symbols

1: Circuit connection structure, 10: circuit-connecting member, 11: insulating material, 12: conductive particles, 14: protrusion, 21: core, 21a: nucleus, 21b: core protrusion, 22: metal layer, 30: first circuit member, 31: first circuit board, 31a: main side of first circuit board, 32: first circuit electrode, 40: second circuit member, 41: second circuit board, 41a: main side of second circuit board, 42: second circuit electrode, H: protrusion 14 height, S: distance between adjacent protrusions 14.

## Best Modes for Carrying Out the Invention

Preferred embodiments of the invention will now be explained in detail, with reference to the accompanying drawings. Throughout the explanation of the drawings, corresponding elements will be referred to by like reference numerals and will be explained only once. For convenience of illustration, the dimensional proportions in the drawings may not match those explained in the text. Furthermore, the present invention is not limited to the embodiments described below.

[Circuit connection structure]

An embodiment of a circuit connection structure of the invention will be explained first.

Fig. 1 is a simplified cross-sectional view showing a first embodiment of a circuit connection structure according to the invention. The circuit connection structure 1 of this embodiment comprises a first circuit member 30 and a second circuit member 40 which are mutually opposing, and a circuit-connecting member 10 which is formed between the first circuit member 30 and second circuit member 40 and connects them. The circuit-connecting member 10 is obtained by curing a circuit-connecting material containing an adhesive composition and conductive particles 12 with multiple protrusions 14 on the surface side. The circuit-connecting member 10 therefore comprises an insulating material 11 and conductive particles 12. The insulating material 11 is composed of a cured adhesive composition.

The first circuit member 30 comprises a circuit board (first circuit board) 31, and a circuit electrode (first circuit electrode) 32 formed on the main side 31a of the circuit board 31. The second circuit member 40 comprises a circuit board 41 and a circuit electrode (first circuit electrode) 42 formed on the main side 41a of the circuit board 41.

The surfaces of the circuit electrodes 32, 42 on the circuit boards 31, 41 are preferably flat. The phrase "the surfaces of the circuit electrodes ... are flat", for the purpose of the invention, means that the sizes of the irregularities on the surfaces of the circuit electrodes are no greater than 20 nm.

The thickness of the circuit electrodes 32, 42 is at least 50 nm. If the thickness of the circuit electrodes 32, 42 is at least 50 nm, it will be possible to sufficiently prevent contact between circuit boards 31, 41 by penetration of the circuit electrodes 32, 42 by the protrusions 14 on the surface side of the conductive particles 12 in the circuit-connecting material, when the circuit-connecting material is pressed by the first circuit member 30 and second circuit member 40. As a result, the contact area between the circuit electrodes 32, 42 and conductive particles 12 will be greater than when the thickness of the circuit electrodes 32, 42 is less than 50 nm, so that the connection resistance will be even lower.

The thickness of the circuit electrode 32, 42 is preferably no greater than 1000 nm and more preferably no greater than 500 nm, from the viewpoint of production cost.

The material for the circuit electrodes 32, 42 may be an Au, Ag, Sn or Pt metal or ITO, IZO, Al, Cr or the like, but the material for the circuit electrodes 32, 42 is most preferably ITO or IZO from the standpoint of electrical connection. The circuit electrodes 32, 42 may be composed entirely of the aforementioned material, or only the outermost layer alone may be composed of the material.

The material for the circuit boards 31, 41 is not particularly restricted, but will normally be an organic insulating material, glass or silicon.

As specific examples for the first circuit member 30 and second circuit member 40 there may be mentioned chip parts such as semiconductor chips, resistor chips and condenser chips, and boards such as printed boards. The circuit members 30, 40 will normally comprise a plurality of circuit electrodes (circuit terminals) 32, 42 (or one in some cases). The form of the circuit connection structure may be a connection structure between an IC chip and a chip-mounting board, or a connection structure between electrical circuits.

The first circuit member 30 may be further provided with an insulating layer between the first circuit electrode 32 and circuit board 31, and the second circuit member 40 may be further provided with an insulating layer between the second circuit electrode 42 and circuit board 41. The insulating layers are not particularly restricted so long as they are

composed of insulating materials, but for most purposes they may be made of organic insulating materials, silicon dioxide or silicon nitride.

In the circuit connection structure 1, the opposing circuit electrode 32 and circuit electrode 42 are electrically connected via the conductive particles 12. That is, the conductive particles 12 directly connect the circuit electrodes 32, 42. Specifically, the protrusions 14 of the conductive particles 12 penetrate the insulating material 11 and contact with the first circuit electrode 32 and second circuit electrode 42.

This adequately reduces the connection resistance between the circuit electrodes 32, 42, allowing satisfactory electrical connection to be established between the circuit electrodes 32, 42. Consequently, smooth current flow can be achieved between the first and second circuit electrodes 32, 42, to allow the function of the circuit to be adequately exhibited.

Some of the protrusions 14 of the conductive particles 12 preferably permeate the circuit electrode 32 or circuit electrode 42. This can further increase the contact area between the circuit electrodes 32, 42 and the protrusions 14 of the conductive particles 12, thus further lowering the connection resistance.

In the circuit connection structure 1, the surface area of either or both the first circuit electrode 32 and second circuit electrode 42 is preferably no greater than 15,000 $\mu m^2$, and the average number of conductive particles between the first circuit electrode 32 and second circuit electrode 42 is preferably 3 or greater. The average number of conductive particles is the average value for the number of conductive particles per circuit electrode 1. This restriction allows the connection resistance between the opposing circuit electrodes 32, 42 to be adequately reduced. An average number of conductive particles of 6 or greater can result in even more satisfactory connection resistance. This is because such a number will lower the connection resistance between the opposing circuit electrodes 32, 42. If the average number of conductive particles between the circuit electrodes 32, 42 is 2 or less, the connection resistance will be too high and the electronic circuits may not function properly.

The circuit-connecting member 10 will now be explained in detail. The circuit-connecting member 10 is in the form of a film and as mentioned above, it is obtained by curing a circuit-connecting material containing an adhesive composition and conductive particles 12 with protrusions 14 on the surface side.

(Conductive particles)

The construction of the conductive particles 12 will be explained first. The conductive particles 12 are composed of particles with a conductive property (particle bodies) and multiple protrusions 14 formed on the surfaces of the particles. The multiple protrusions 14 are composed of a conductive metal. Fig. 2(a) is a cross-sectional view showing an example of a conductive particle in the circuit-connecting member of a circuit connection structure according to the invention, and (b) is a cross-sectional view showing another example of a conductive particle.

The conductive particle 12 shown in Fig. 2(a) is composed of a core 21 and a metal layer 22 formed on the surface of the core 21. The core 21 is composed of a nucleus 2 1 a and protrusions 21b formed on the surface of the nucleus 21a, and the metal layer 22 has multiple protrusions 14 on the surface side. The metal layer 22 covers the core 21 and protrudes out at locations corresponding to the protrusions 21b, with these protruding sections forming the protrusions 14.

The core 21 is preferably composed of an organic high molecular compound. Such a material is less expensive and has a wider elastic deformation range for dimensional change during thermal expansion and contact bonding compared to metal cores, and will therefore render the core 21 more suitable as a circuit-connecting material.

As examples of organic high molecular compounds for the nucleus 21a of the core 21 there may be mentioned acrylic resins, styrene resins, benzoguanamine resins, silicone resins, polybutadiene resins, and copolymers of the foregoing, while crosslinked forms thereof may also be used. The mean particle size of the nucleus 21a of the core 21 may be appropriately designed according to the purpose of use, but it is preferably 1-10 $\mu$m, more preferably 2-8 $\mu$m and even more preferably 3-5 $\mu$m. If the mean particle size is less than 1 $\mu$m, secondary aggregation of the particles will tend to occur, resulting in an insufficient insulating property between the adjacent circuits. On the other hand, if the mean particle size is greater than 10 $\mu$m the increased size will also tend to result in an insufficient insulating property between adjacent circuits.

As examples of organic high molecular compounds for the protrusions 21b of the core 21 there may be mentioned acrylic resins, styrene resins, benzoguanamine resins, silicone resins, polybutadiene resins and copolymers of the foregoing, and their crosslinked forms may also be used. The organic high molecular compound forming the protrusions 21 b may be the same as or different from the organic high molecular compound forming the nucleus 21a.

The core 21 may be formed by adsorbing numerous protrusions 2 1 b with smaller diameters than the nucleus 2 1 a onto the surface of the nucleus 21a. The method of adsorbing the protrusions 21b onto the surface of the nucleus 21 a may involve, for example, surface-treating one or both particles with a dilute solution of a coupling agent such as silane, aluminum or titanium and an adhesive, and then mixing them to cause their adhesion.

The material for the metal layer 22 is Ni or a Ni alloy, and as examples of nickel alloys there may be mentioned

Ni-B, Ni-W, Ni-B, Ni-W-Co, Ni-Fe and Ni-Cr. Ni is preferred because it is hard and readily permeates into the circuit electrodes 32, 42. The metal layer 22 may be formed by plating such metals onto the core 21 by an electroless plating method. Electroless plating methods are generally categorized as either batch or continuous dropping methods, and the metal layer 22 may be formed by either type.

The thickness of the metal layer 22 (plating thickness) is preferably 50-170 nm and more preferably 50-150 nm. A metal layer 22 thickness within this range can further lower the connection resistance between the circuit electrodes 32, 42. A metal layer 22 thickness of less than 50 nm will tend to cause plating defects, while a thickness of greater than 170 nm will cause aggregation between conductive particles, potentially resulting in shorting between adjacent circuit electrodes. The conductive particles 12 according to the invention may have their cores 21 partially exposed. In such cases, the coverage factor of the metal layer 22 with respect to the surface area of the core 21 is preferably at least 70%, more preferably at least 80% and even more preferably at least 90%, from the viewpoint of connection reliability.

The heights H of the protrusions 14 of the conductive particles 12 are preferably 50-500 nm and even more preferably 100-300 nm. The distance S between adjacent protrusions 14 is preferably no greater than 1000 nm and even more preferably no greater than 500 nm.

The distance S between adjacent protrusions 14 is preferably at least 50 nm, so that the adhesive composition does not permeate between the conductive particles 12 and circuit electrodes 32, 42 and sufficient contact is established between the conductive particles 12 and circuit electrodes 32, 42. The heights H of the protrusions 14 of the conductive particles 12 and the distance S between adjacent protrusions 14 can be measured using an electron microscope.

Each conductive particle 12 may have the core 21 composed entirely of the nucleus 21 a, as shown in Fig. 2 (b). In other words, the protrusions 21b on the conductive particle 12 shown in Fig. 2(a) may be absent. The conductive particle 12 shown in Fig. 2(b) can be obtained by metal plating the surface of the core 21 to form a metal layer 22 on the surface of the core 21.

A plating method for formation of the protrusions 14 will now be explained. The protrusions 14 may be formed, for example, by adding a plating solution with a higher concentration than the initially used plating solution, during the plating reaction to create a non-uniform plating solution concentration. The pH of the plating solution can also be adjusted, for example to a pH of 6 for a nickel plating solution, to obtain a metal layer 22 with a nodular metal layer, i.e. protrusions 14 (Mochizuki et al., Hyoumen Gijutsu, Vol.48, No.4, p.429-432, 1997). Also, a smooth metal layer (coating) can be obtained when glycine is used as a complexing agent to promote plating bath stability, while a nodular coating, i.e. a metal layer 22 with protrusions 14, can be obtained when tartaric acid or DL-malic acid is used (Ogiwara et al., Amorphous Platings, Vol.36, p.35-37, 1994; Ogiwara et al., Institute of Circuit Mounting, Vol.10, No.3, p.148-152, 1995).

The metal layer 22 may be composed of a single metal layer or a plurality of metal layers.

(Adhesive composition)

The adhesive composition will now be explained in detail.
The adhesive composition has an insulating property and an adhesive property. As adhesive compositions there are preferred (1) compositions comprising an epoxy resin and a latent curing agent for the epoxy resin, (2) compositions comprising a radical-polymerizing substance and a curing agent that generates free radicals by heat, and mixtures of (1) and (2).

The (1) compositions comprising an epoxy resin and a latent curing agent for the epoxy resin will be explained first.
As epoxy resins there may be mentioned bisphenol A-type epoxy resins, bisphenol F-type epoxy resins, bisphenol S-type epoxy resins, phenol-novolac-type epoxy resins, cresol-novolac-type epoxy resins, bisphenol A-novolac-type epoxy resins, bisphenol F-novolac-type epoxy resins, alicyclic epoxy resins, glycidyl ester-type epoxy resins, glycidylamine-type epoxy resins, hydantoin-type epoxy resins, isocyanurate-type epoxy resins, aliphatic straight-chain epoxy resins, and the like. These epoxy resins may be halogenated or hydrogenated.
These epoxy resins may also be used in combinations of two or more.

The latent curing agent for the epoxy resin may be any one capable of curing the epoxy resin, and as such latent curing agents there may be mentioned anionic polymerizable catalyst-type curing agents, cationic polymerizable catalyst-type curing agents and polyaddition-type curing agents. Any of these may be used alone or in mixtures of two or more. Preferred among these are anionic and cationic polymerizable catalyst-type curing agents since they have excellent fast-curing properties and do not require special consideration in regard to chemical equivalents.

As anionic or cationic polymerizable catalyst-type curing agents there may be mentioned imidazole-based agents, hydrazide-based agents, boron trifluoride-amine complexes, sulfonium salts, amineimides, diaminomaleonitrile, melamine and its derivatives, polyamine salts, dicyandiamide and the like, and modified forms of the foregoing may also be used. As polyaddition-type curing agents there may be mentioned polyamines, polymercaptanes, polyphenols, acid anhydrides and the like.

When a tertiary amine or imidazole is added as an anionic polymerizable catalyst-type curing agent, the epoxy

resin is cured by heating at a moderate temperature of about 160°C-200°C for between several tens of seconds and several hours. This is preferred because it lengthens the pot life.

Preferred examples of cationic polymerizable catalyst-type curing agents include photosensitive onium salts that cure epoxy resins under energy ray exposure (mainly aromatic diazonium salts, aromatic sulfonium salts and the like). Aliphatic sulfonium salts are among those that are activated and cure epoxy resins by heat instead of energy ray exposure. Such curing agents are preferred because of their fast-curing properties.

Microencapsulated forms obtained by covering these latent curing agents with polyurethane-based or polyester-based polymer substances or inorganic materials such as metal thin-films of nickel or copper, or calcium silicate, are preferred as they can lengthen the pot life.

The (2) composition comprising a radical-polymerizing substance and a curing agent which generates free radicals in response to heating will now be described.

The radical-polymerizing substance is a substance having functional groups that polymerize by radicals. As such radical-polymerizing substances there may be mentioned acrylate (including corresponding methacrylate, same hereunder) compounds, acryloxy (including corresponding methacryloxy, same hereunder) compounds, maleimide compounds, citraconimide resins, nadimide resins and the like. The radical-polymerizing substance may be used as a monomer or oligomer, or a monomer and oligomer may be used in combination.

As specific examples of acrylate compounds there may be mentioned methyl acrylate, ethyl acrylate, isopropyl acrylate, isobutyl acrylate, ethyleneglycol diacrylate, diethyleneglycol diacrylate, trimethylolpropane triacrylate, tetramethylolmethane tetraacrylate, 2-hydroxy-1,3-diacryloxypropane, 2,2-bis[4-(acryloxymethoxy)phenyl]propane, 2,2-bis[4-(acryloxypolyethoxy)phenyl]propane, dicyclopentenyl acrylate, tricyclodecanyl acrylate, tris(acryloyloxyethyl) isocyanurate, urethane acrylate and the like. Any of these may be used alone or in mixtures of two or more. If necessary, an appropriate amount of a polymerization inhibitor such as hydroquinone or methyl ether hydroquinone may be used. From the viewpoint of improving the heat resistance, the acrylate compound preferably has at least one substituent selected from the group consisting of dicyclopentenyl, tricyclodecanyl and triazine rings.

The maleimide compound preferably has two or more maleimide groups in the molecule. As examples of such maleimide compounds there may be mentioned 1-methyl-2,4-bismaleimidebenzene, N,N'-m-phenylenebismaleimide, N,N'-p-phenylenebismaleimide, N,N'-m-toluilenebismaleimide, N,N'-4,4-biphenylenebismaleimide, N,N'-4,4-(3,3'-dimethylbiphenylene)bismaleimide, N,N'-4,4-(3,3'-dimethyldiphenylmethane)bismaleimide, N,N'-4,4-(3,3'-diethyldiphenylmethane)bismaleimide, N,N'-4,4-diphenylmethanebismaleimide, N,N'-4,4-diphenylpropanebismaleimide, N,N'-3,3'-diphenylsulfonebismaleimide, N,N'-4,4-diphenyl etherbismaleimide, 2,2-bis(4-(4-maleimidephenoxy)phenyl)propane, 2,2-bis(3-s-butyl-4,8-(4-maleimidephenoxy)phenyl)propane, 1,1-bis(4-(4-maleimidephenoxy)phenyl)decane, 4,4'-cyclohexylidene-bis(1-(4-maleimidephenoxy)-2-cyclohexylbenzene and 2,2-bis(4-(4-maleimidephenoxy)phenyl)hexafluoropropane. Any of these may be used alone or in mixtures of two or more.

The citraconimide resin is a compound obtained by copolymerizing a citraconimide compound with at least one citraconimide group in the molecule. As examples of citraconimide compounds there may be mentioned phenylcitraconimide, 1-methyl-2,4-biscitraconimidebenzene, N,N'-m-phenylenebiscitraconimide, N,N'-p-phenylenebiscitraconimide, N,N'-4,4-biphenylenebiscitraconimide, N,N'-4,4-(3,3-dimethylbiphenylene)biscitraconimide, N,N'-4,4-(3,3-dimethyldiphenylmethane)biscitraconimide, N,N'-4,4-(3,3-diethyldiphenylmethane)biscitraconimide, N,N'-4,4-diphenylmethanebiscitraconimide, N,N'-4,4-diphenylpropancbiscitraconimide, N,N'-4,4-diphenyl etherbiscitraconimide, N,N'-4,4-diphenylsulfonebiscitraconimide, 2,2-bis(4-(4-citraconimidephenoxy)phenyl)propane, 2,2-bis(3-s-butyl-3,4-(4-citraconimidephenoxy)phenyl)propane, 1,1-bis(4-(4-citraconimidephenoxy)phenyl)decane, 4,4'-cyclohexylidene-bis(1-(4-citraconimidephenoxy)phenoxy)-2-cycloh exylbenzene and 2,2-bis(4-(4-citraconimidephenoxy)phenyl)hexafluoropropane. Any of these may be used alone or in mixtures of two or more.

The nadimide resin is a compound obtained by copolymerizing a nadimide compound with at least one nadimide group in the molecule. As examples of nadimide compounds there may be mentioned phenylnadimide, 1-methyl-2,4-bisnadimidebenzene, N,N'-m-phenylenebisnadimide, N,N'-p-phenylenebisnadimide, N,N'-4,4-biphenylenebisnadimide, N,N'-4,4-(3,3-dimethylbiphenylene)bisnadimide, N,N'-4,4-(3,3-dimethyldiphenylmethane)bisnadimide, N,N'-4,4-(3,3-diethyldiphenylmethane)bisnadimide, N,N'-4,4-diphenylmethanebisnadimide, N,N'-4,4-diphenylpropanebisnadimide, N,N'-4,4-diphenyl etherbisnadimide, N,N'-4,4-diphenylsulfonebisnadimide, 2,2-bis(4-(4-nadimidephenoxy)phenyl)propane, 2,2-bis(3-s-butyl-3,4-(4-nadimidephenoxy)phenyl)propane, 1,1-bis(4-(4-nadimidephenoxy)phenyl)decane, 4,4'-cyclohexylidene-bis(1-(4-nadimidephenoxy)phenoxy)-2-cyclohexyl benzene and 2,2-bis(4-(4-nadimidephenoxy)phenyl)hexafluoropropane. Any of these may likewise be used alone or in mixtures of two or more.

A radical-polymerizing substance having a phosphoric acid ester structure represented by the following chemical formula (I) is preferably used together with the aforementioned radical-polymerizing substance. This will improve the adhesive strength with respect to inorganic material surfaces such as metals, thus rendering the circuit-connecting material suitable for bonding between circuit electrodes.

[Chemical Formula 1]

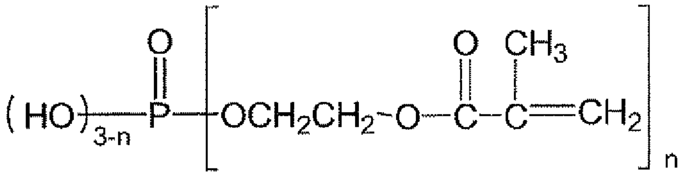

· · · (I)

[In the formula, n represents an integer of 1-3.]

The radical-polymerizing substance with a phosphoric acid ester structure is obtained by reaction between phosphoric anhydride and 2-hydroxyethyl (meth)acrylate. As radical-polymerizing substances with phosphoric acid ester structures there may be mentioned, specifically, mono(2-methacryloyloxyethyl)acid phosphate and di(2-methacryloyloxyethyl)acid phosphate. Any of these may be used alone or in mixtures of two or more.

The content of the radical-polymerizing substance with a phosphoric acid ester structure represented by chemical formula (I) above is preferably 0.01-50 parts by weight and more preferably 0.5-5 parts by weight with respect to 100 parts by weight as the total of the radical-polymerizing substance and the film-forming material that is added as necessary.

The radical-polymerizing substance may be used together with allyl acrylate. In such cases, the allyl acrylate content is preferably 0.1-10 parts by weight and more preferably 0.5-5 parts by weight with respect to 100 parts by weight as the total of the radical-polymerizing substance and the film-forming material that is added as necessary.

The curing agent which generates free radicals upon heating is a curing agent that generates free radicals by decomposition upon heating. As such curing agents there may be mentioned peroxide compounds and azo-based compounds. Such curing agents may be appropriately selected as appropriate for the desired connection temperature, connection time and pot life. From the standpoint of achieving both high reactivity and a long pot life, an organic peroxide with a 10 hour half-life temperature of 40°C or higher and a 1 minute half-life temperature of no higher than 180°C is preferred, and an organic peroxide with a 10 hour half-life temperature of 60°C or higher and a 1 minute half-life temperature of no higher than 170°C, is more preferred.

For a connection time of up to 25 seconds, the curing agent content is approximately 2-10 parts by weight and more preferably 4-8 parts by weight with respect to 100 parts by weight as the total of the radical-polymerizing substance and the film-forming material which is added as necessary, in order to obtain a sufficient reaction rate. If no limit on the connection time can be assumed, the curing agent content is preferably 0.05-20 parts by weight and more preferably 0.1-10 parts by weight with respect to 100 parts by weight as the total of the radical-polymerizing substance and the film-forming material which is added as necessary.

As curing agents that generate free radicals upon heating there may be mentioned, more specifically, diacyl peroxides, peroxy dicarbonates, peroxy ester-peroxy ketals, dialkyl peroxides, hydroperoxides, silyl peroxides and the like. From the viewpoint of inhibiting corrosion of the circuit electrodes 32, 42 the curing agent preferably has a chloride ion or organic acid concentration of no greater than 5000 ppm, and more preferably the content of organic acids generated after thermal decomposition is low. As such curing agents there may be mentioned, specifically, peroxy esters, dialkyl peroxides, hydroperoxides, silyl peroxides and the like, with peroxy esters being especially preferred for high reactivity. These curing agents may also be used in appropriate mixtures.

As peroxy esters there may be mentioned cumylperoxy neodecanoate, 1,1,3,3-tetramethylbutylperoxy neodecanoate, 1-cyclohexyl-1-methylethylperoxy neodecanoate, t-hexylperoxy neodecanoate, t-butylperoxy pivalate, 1,1,3,3-tetramethylbutylperoxy2-ethyl hexanonate, 2,5-dimethyl-2,5-di(2-ethylhexanoylperoxy)hexane, 1-cyclohexyl-1-methylethylperoxy-2-ethyl hexanonate, t-hexylperoxy-2-ethyl hexanonate, t-butylperoxy-2-ethyl hexanonate, t-butylperoxy isobutyrate, 1,1-bis(t-butylperoxy)cyclohexane, t-hexylperoxyisopropyl monocarbonate, t-butylperoxy-3,5,5-trimethyl hexanonate, t-butylperoxy laurate, 2,5-dimethyl-2,5-di(m-toluoylperoxy)hexane, t-butylperoxyisopropyl monocarbonate, t-butylperoxy-2-ethylhexyl monocarbonate, t-hexylperoxybenzoate and t-butylperoxy acetate.

As dialkyl peroxides there may be mentioned $\alpha,\alpha'$-bis(t-butylperoxy)diisopropylbenzene, dicumyl peroxide, 2,5-dimethyl-2,5-di(t-butylperoxy)hexane and t-butylcumyl peroxide.

As hydroperoxides there may be mentioned diisopropylbenzene hydroperoxide and cumene hydroperoxide.

As diacyl peroxides there may be mentioned isobutyl peroxide, 2,4-dichlorobenzoyl peroxide, 3,5,5-trimethylhexanoyl peroxide, octanoyl peroxide, lauroyl peroxide, stearoyl peroxide, succinic peroxide, benzoylperoxytoluene and benzoyl peroxide.

As peroxy dicarbonates there may be mentioned di-n-propylperoxy dicarbonate, diisopropylperoxy dicarbonate, bis(4-t-butylcyclohexyl)peroxy dicarbonate, di-2-ethoxymethoxyperoxy dicarbonate, di(2-ethylhexylperoxy)dicarbonate, dimethoxybutylperoxy dicarbonate and di(3-methyl-3-methoxybutylperoxy)dicarbonate.

As peroxy ketals there may be mentioned 1,1-bis(t-hexylperoxy)-3,3,5-trimethylcyclohexane, 1,1-bis(t-hexylperoxy)cyclohexane, 1,1-bis(t-butylperoxy)-3,3,5-trimethylcyclohexane, 1,1-(t-butylperoxy)cyc1ododecane and 2,2-bis(t-butylperoxy)decane.

As silyl peroxides there may be mentioned t-butyltrimethylsilyl peroxide, bis(t-butyl)dimethylsilyl peroxide, t-butyltrivinylsilyl peroxide, bis(t-butyl)divinylsilyl peroxide, tris(t-butyl)vinylsilyl peroxide, t-butyltriallylsilyl peroxide, bis(t-butyl)diallylsilyl peroxide and tris(t-butyl)allylsilyl peroxide.

These curing agents may be used alone or in combinations of two or more, and may also be used in admixture with triggers or inhibitors. These curing agents are preferably used in microencapsulated form by coating with a polyurethane-based or polyester-based macromolecular compound. Microencapsulated curing agents are preferred for a longer pot life.

The adhesive composition may also contain an added film-forming material if necessary. A film-forming material is a material which, when a liquid substance is solidified as a structural composition and formed into a film, facilitates handling of the film and confers mechanical properties that prevent tearing, cracking or sticking, thereby permitting it to be handled as a film under ordinary conditions (ordinary temperature and pressure). As film-forming materials there may be mentioned phenoxy resins, polyvinyl formal resins, polystyrene resins, polyvinyl butyral resins, polyester resins, polyamide resins, xylene resins, polyurethane resins and the like. Phenoxy resins are preferred among these because of their excellent adhesion, compatibility, heat resistance and mechanical strength.

A phenoxy resin is a resin obtained either by reacting a bifunctional phenol with an epihalohydrin until polymerization, or by polyaddition of a bifunctional epoxy resin and a bifunctional phenol. The phenoxy resin may be obtained by, for example, reacting 1 mol of a bifunctional phenol with 0.985-1.015 mol of an epihalohydrin in a non-reactive solvent at a temperature of 40-120°C, in the presence of a catalyst such as an alkali metal hydroxide. From the viewpoint of resin mechanical properties and thermal properties, particularly preferred phenoxy resins are those obtained by polyaddition reaction of a bifunctional epoxy resin and a bifunctional phenol at an epoxy group/phenol hydroxyl group equivalent ratio of 1/0.9-1/1.1, with heating to 50-200°C under conditions with a reaction solid content of no greater than 50 parts by weight, in an amide-based, ether-based, ketone-based, lactone-based or alcohol-based solvent with a boiling point of 120°C or higher, in the presence of a catalyst such as an alkali metal compound, organic phosphorus-based compound, cyclic amine-based compound or the like.

As bifunctional epoxy resins there may be mentioned bisphenol A-type epoxy resins, bisphenol F-type epoxy resins, bisphenol AD-type epoxy resins, bisphenol S-type epoxy resins, biphenyldiglycidyl ethers, methyl-substituted biphenyldiglycidyl ethers and the like. Bifunctional phenols have two phenolic hydroxyl groups. As examples of bifunctional phenols there may be mentioned hydroquinones, and bisphenols such as bisphenol A, bisphenol F, bisphenol AD, bisphenol S, bisphenolfluorene, methyl-substituted bisphenolfluorene, dihydroxybiphenyl and methyl-substituted dihydroxybiphenyl. The phenoxy resin may be modified with radical-polymerizing functional groups or with other reactive compounds (for example, epoxy-modified). A phenoxy resin may be used alone, or two or more different ones may be used in combination.

The adhesive composition may also contain a polymer or copolymer comprising at least one from among acrylic acid, acrylic acid ester, methacrylic acid ester and acrylonitrile as a monomer component. It is preferred to also use a copolymer-based acrylic rubber containing glycidyl acrylate or glycidyl methacrylate with a glycidyl ether group, for excellent stress relaxation. The weight-average molecular weight of the acrylic rubber is preferably at least 200,000 from the viewpoint of increasing the cohesion of the adhesive.

The content of the conductive particles 12 is preferably 0.1-30 parts by volume with respect to 100 parts by volume of the adhesive composition, and the content may be selected depending on the purpose of use. From the viewpoint of preventing shorting between the circuit electrodes 32, 42 by excess conductive particles 12, the content of the conductive particles 12 is more preferably 0.1-10 parts by volume.

The adhesive composition may also contain rubber fine particles, or a filler, softening agent, accelerator, age inhibitor, coloring agent, flame retardant, thixotropic agent, coupling agent, phenol resin, melamine resin, isocyanate or the like.

The rubber fine particles may have a mean particle size of up to twice the mean particle size of the conductive particles 12, and they may have a storage elastic modulus of up to 1/2 the storage elastic modulus of the conductive particles 12 and adhesive composition at room temperature (25°C). Fine particles wherein the material of the rubber fine particles is silicone, an acrylic emulsion, SBR, NBR or polybutadiene rubber are particularly suitable, either alone or in combinations of two or more types. Three-dimensionally crosslinked rubber fine particles have excellent solvent resistance and readily disperse in the adhesive composition.

A filler is preferably included in the adhesive composition to improve the connection reliability. The filler used may be any one with a maximum size that is up to 1/2 the mean particle size of the conductive particles 12. A filler particle size that is larger than the conductive particles may interfere with flattening of the conductive particles. If non-conductive particles are used in combination therewith, any filler with a size of no greater than the sizes of the non-conductive particles may be used. The content of the filler is preferably 5-60 parts by volume with respect to 100 parts

by volume of the adhesive composition. If the content is greater than 60 parts by volume, the effect of improved connection reliability will tend to be saturated, while if it is less than 5 parts by volume the effect of addition of the filler will tend to be insufficiently exhibited.

Preferred coupling agents, from the viewpoint of adhesion, are compounds containing one or more groups selected from among vinyl, acrylic, epoxy and isocyanate groups.

A film-like circuit-connecting material may be formed by coating a support (a PET (polyethylene terephthalate) film or the like) with the circuit-connecting material using a coating apparatus (not shown), and drying it with hot air for a prescribed time period.

[Process for production of circuit connection structure]

A process for production of the circuit connection structure 1 mentioned above will now be described.

First, there are prepared a first circuit member 30 with a first circuit electrode 32, a second circuit member 40 with a second circuit electrode 42, and a circuit-connecting material. The circuit-connecting material may be, for example, a circuit-connecting material shaped into a film (hereinafter referred to as "circuit-connecting material film"). The circuit-connecting material film comprises the aforementioned adhesive composition and conductive particles 12. The thickness of the circuit-connecting material film is preferably 10-50 μm.

The circuit-connecting material film is then placed over the first circuit member 30. The second circuit member 40 is placed on the circuit-connecting material film with the first circuit electrode 32 and second circuit electrode 42 facing each other. This situates the circuit-connecting material film between the first circuit member 30 and second circuit member 40. The circuit-connecting material film is easy to manage since it is in the form of a film. Thus, the circuit-connecting material film can be easily situated between the first circuit member 30 and second circuit member 40 when they are connected, thus facilitating the connection operation for the first circuit member 30 and second circuit member 40.

Next, the circuit-connecting material film is heated and pressed through the first circuit member 30 and second circuit member 40 for curing treatment to form a circuit-connecting member 10 between the first and second circuit members 30, 40. The curing treatment may be carried out by an ordinary method, which may be appropriately selected depending on the adhesive composition. When the outermost layer of the conductive particles 12 in the circuit-connecting material is Ni, the protrusions 14 will permeate deeper into the first or second circuit electrodes 32, 42 than conductive particles with Au as the outermost layer, since Ni is harder than Au, and therefore the contact area between the conductive particles 12 and circuit electrodes 32, 42 will be increased. In addition, if the thickness of the first and second circuit electrodes 32, 42 is at least 50 nm, the protrusions 14 of the conductive particles 12 will penetrate further into the first or second circuit electrodes 32, 42, thus helping to prevent reduction in the contact area. Curing treatment of the circuit-connecting material results in curing of the adhesive composition, with high adhesive strength between the first circuit member 30 and second circuit member 40, so that firm contact between the conductive particles 12 and the first and second circuit electrodes 32, 42 can be maintained for prolonged periods.

It is thus possible to sufficiently lower connection resistance between the opposing first and second circuit electrodes 32, 42 regardless of whether or not irregularities are present on the surface of the first and/or second circuit electrode 32, 42, in order to achieve satisfactory electrical connection between the first circuit electrode 32 and second circuit electrode 42 while adequately increasing the long-term reliability of electrical characteristics between the first and second circuit electrodes 32, 42.

Incidentally, although the circuit connection structure 1 of this embodiment is fabricated using a circuit-connecting material film, a circuit-connecting material that is not in the form of a film may be used instead of a circuit-connecting material film. In this case as well, dissolving the circuit-connecting material in a solvent and coating and drying the solution on either or both the first circuit member 30 and second circuit member 40 allows it to be situated between the first and second circuit members 30, 40.

<u>Examples</u>

The present invention will now be explained in greater detail based on examples and comparative examples, with the understanding that the invention is not limited to the examples.

(Formation of conductive particles)

Cores with particle sizes of approximately 5 μm were obtained by suspension polymerization with different mixing ratios of tetramethylolmethane tetraacrylate, divinylbenzene and styrene monomer, using benzoyl peroxide as the polymerization initiator, and classifying the obtained polymer.

The surfaces of the obtained cores were subjected to electroless Ni plating treatment to obtain conductive particles No.1 having a Ni layer (metal layer) with a uniform thickness of 100 nm.

The conductive particles No.1 were subjected to substitution plating with Au to a 25 nm thickness, forming an Au layer with a uniform thickness to obtain conductive particles No.3.

The conductive particles No.2 were subjected to further substitution plating with Au, forming an Au layer with numerous protrusions, to obtain conductive particles No.4.

The conductive particles No. 1-4 were observed with an electron microscope (S-800 by Hitachi, Ltd.), and the mean height of the protrusions and the mean distance between adjacent protrusions were measured. The results are shown in Table 1.

[Table 1]

| Conductive particles | Outermost layer | Height of bumps (nm) | Distance between bumps (nm) |
|---|---|---|---|
| No. 1 | Ni | No bumps | No bumps |
| No. 2 | Ni | 100 | 500 |
| No. 3 | Au | No bumps | No bumps |
| No. 4 | Au | 100 | 500 |

(Fabrication of circuit-connecting material A)

A phenoxy resin was synthesized from a bisphenol A-type epoxy resin and a phenol compound with a fluorene ring structure in the molecule (4,4'-(9-fluorenylidene)-diphenyl), and the resin was dissolved in a mixed solvent of toluene/ethyl acetate = 50/50 (weight ratio) to form a solution with a solid content of 40 wt%.

Next, an acrylic rubber (copolymer comprising 40 parts by weight butyl acrylate-30 parts by weight ethyl acrylate-30 parts by weight acrylonitrile-3 parts by weight glycidyl methacrylate, weight-average molecular weight: 800,000) was prepared as the rubber component, and the acrylic rubber was dissolved in a mixed solvent of toluene/ethyl acetate = 50/50 (weight ratio) to obtain a solution with a solid content of 15 wt%.

A liquid curing agent-containing epoxy resin (epoxy equivalent: 202) was also prepared containing a microencapsulated latent curing agent (microencapsulated amine-based curing agent), a bisphenol F-type epoxy resin and a naphthalene-type epoxy resin in a weight ratio of 34:49:17.

The above-mentioned materials were mixed in a proportion of phenoxy resin/acrylic rubber/curing agent-containing epoxy resin = 20 g/30 g/50 g as solid weight, to produce an (epoxy) adhesive composition-containing solution. In 100 parts by weight of the adhesive composition-containing solution there was dispersed 5 parts by weight of conductive particles No.2 to prepare a circuit-connecting material-containing solution.

A coating apparatus was used to coat the circuit-connecting material-containing solution onto a 50 μm-thick polyethylene terephthalate (PET) film surface-treated on one side, and the coating was dried with hot air at 70°C for 3 minutes to form a circuit-connecting material film A to a thickness of 20 μm on the PET film.

(Fabrication of circuit-connecting material B)

There was dissolved 50 g of a phenoxy resin (trade name: PKHC, product of Union Carbide Corp., weight-average molecular weight: 5,000) in a mixed solvent of toluene/ethyl acetate = 50/50 (weight ratio) to prepare a phenoxy resin solution with a solid content of 40 wt%. With this there were combined 400 parts by weight of polycaprolactonediol with a weight-average molecular weight of 800, 131 parts by weight of 2-hydroxypropyl acrylate, 0.5 part by weight of dibutyltin dilaurate as a catalyst and 1.0 part by weight of hydroquinonemonomethyl ether as a polymerization inhibitor, while stirring and heating at 50°C.

Next, 222 parts by weight of isophorone diisocyanate was added dropwise to the mixture and the temperature was raised to 80°C while stirring for urethanation reaction. Upon confirming at least a 99% isocyanate group reaction rate, the reaction temperature was lowered to obtain urethane acrylate.

The phenoxy resin solution measured out in an amount for 50 g solid weight from the phenoxy resin solution prepared as described above, 49 g of urethane acrylate, 1 g of a phosphoric acid ester-type acrylate and 5 g of t-hexylperoxy-2-ethyl hexanonate as a curing agent that generates free radicals by heat, were mixed to obtain an (acrylic) adhesive composition-containing solution. Also, in 100 parts by weight of the adhesive composition-containing solution there was dispersed 5 parts by weight of conductive particles No.2 to prepare a circuit-connecting material-containing solution.

A coating apparatus was used to coat the circuit-connecting material-containing solution onto a 50 μm-thick PET film surface-treated on one side, and the coating was dried with hot air at 70°C for 3 minutes to form a circuit-connecting material film B to a thickness of 20 μm on the PET film.

(Fabrication of circuit-connecting material C)

Circuit-connecting material C was obtained by the same procedure as for circuit-connecting material A, except that conductive particles No.1 were used instead of the conductive particles No.2 in circuit-connecting material A.

(Fabrication of circuit-connecting material D)

Circuit-connecting material D was obtained by the same procedure as for circuit-connecting material A, except that conductive particles No.3 were used instead of the conductive particles No.2 in circuit-connecting material A.

(Fabrication of circuit-connecting material E)

Circuit-connecting material E was obtained by the same procedure as for circuit-connecting material A, except that conductive particles No.4 were used instead of the conductive particles No.2 in circuit-connecting material A.

(Example 1)

A flexible circuit board (hereinafter, FPC) was prepared having a two-layer structure composed of a polyimide film (thickness: 38 μm) and a Sn-plated Cu foil (thickness: 8 μm), as a first circuit member. The circuit of the FPC had a line width of 18 μm and a pitch of 50 μm.

Next, a glass panel (thickness: 1.1 mm) was prepared comprising an ITO circuit electrode (thickness: 50 nm, surface resistance: <20 Ω) on the surface, as a second circuit member. The circuit of the second circuit member had a line width of 25 μm and a pitch of 50 μm. Circuit-connecting material A cut to a prescribed size (1.5 × 30 mm) was attached onto the second circuit member, and connection was established by heating and pressing at 70°C, 1.0 MPa for 5 seconds. The PET film was then released, the FPC was positioned so that the circuit-connecting material film was sandwiched by the FPC and second circuit member, and the circuit of the FPC and the circuit of the second circuit member were aligned. This was heated and pressed from above the FPC under conditions of 180°C, 3 MPa, 15 seconds for main connection between the FPC and second circuit member. A circuit connection structure for Example 1 was thus obtained.

(Example 2)

An FPC was prepared in the same manner as Example 1 as the first circuit member. Next, a glass panel (thickness: 1.1 mm) was prepared comprising an IZO circuit electrode (thickness: 50 nm, surface resistance: <20 Ω) on the surface, as a second circuit member. The circuit of the second circuit member had a line width of 25 μm and a pitch of 50 μm. Pre-connection of the circuit-connecting material A and the main connection were carried out in the same manner as the connection in Example 1, to obtain a circuit connection structure for Example 2.

(Example 3)

An FPC was prepared in the same manner as Example 1 as the first circuit member. Next, a glass panel (thickness: 1.1 mm) was prepared comprising a circuit electrode with an ITO (outermost layer, thickness: 50 nm)/Cr (thickness: 200 nm) bilayer structure (surface resistance: <20 Ω) on the surface, as a second circuit member. The circuit of the second circuit member had a line width of 25 μm and a pitch of 50 μm. Pre-connection of the circuit-connecting material A and the main connection were carried out in the same manner as the connection in Example 1 to obtain a circuit member structure for Example 3.

(Example 4)

An FPC was prepared in the same manner as Example 1 as the first circuit member. Next, a glass panel (thickness: 1.1 mm) was prepared comprising a circuit electrode with an ITO (outermost layer, thickness: 50 nm)/Ti (thickness: 100 nm/Al (thickness: 200 nm)/Ti (thickness: 100 nm) four-layer structure (surface resistance: <20 Ω) on the surface, as a second circuit member. The circuit of the second circuit member had a line width of 25 μm and a pitch of 50 μm. Pre-connection of the circuit-connecting material A and the main connection were carried out in the same manner as the connection in Example 1 to obtain a circuit connection structure for Example 4.

(Example 5)

An FPC was prepared in the same manner as Example 1 as the first circuit member. Next, a glass panel (thickness: 1.1 mm) was prepared comprising an Al circuit electrode (thickness: 200 nm, surface resistance: <5 Ω) on the surface, as a second circuit member. The circuit of the second circuit member had a line width of 25 μm and a pitch of 50 μm. Pre-connection of the circuit-connecting material A and the main connection were carried out in the same manner as the connection in Example 1 to obtain a circuit connection structure for Example 5.

(Example 6)

An FPC was prepared in the same manner as Example 1 as the first circuit member. Next, a glass panel was prepared comprising the same type of ITO circuit electrode as for Example 1 (thickness: 50 nm), as a second circuit member. Circuit-connecting material B cut to a prescribed size (1.5 × 30 mm) was attached onto the second circuit member, and connection was established by heating and pressing at 70°C, 1.0 MPa for 3 seconds. The PET film was then released, the FPC was positioned so that the circuit-connecting material film was sandwiched by the FPC and second circuit member, and the circuit of the FPC and the circuit of the second circuit member were aligned. This was heated and pressed from above the FPC under conditions of 170°C, 3 MPa, 10 seconds for main connection between the FPC and second circuit member. A circuit connection structure for Example 6 was thus obtained.

(Example 7)

An FPC was prepared in the same manner as Example 1 as the first circuit member. Next, a glass panel was prepared comprising the same type of IZO circuit electrode as for Example 2, as a second circuit member. Pre-connection of the circuit-connecting material B and the main connection were carried out in the same manner as the connection in Example 6 to obtain a circuit connection structure for Example 7.

(Example 8)

An FPC was prepared in the same manner as Example 1 as the first circuit member. Next, a glass panel was prepared comprising the same type of ITO/Cr circuit electrode as for Example 3, as a second circuit member. Pre-connection of the circuit-connecting material B and the main connection were carried out in the same manner as the connection in Example 6 to obtain a circuit connection structure for Example 8.

(Example 9)

An FPC was prepared in the same manner as Example 1 as the first circuit member. Next, a glass panel was prepared comprising the same type of ITO/Ti/Al/Ti circuit electrode as for Example 4, as a second circuit member. Pre-connection of the circuit-connecting material B and the main connection were carried out in the same manner as the connection in Example 6 to obtain a circuit connection structure for Example 9.

(Example 10)

An FPC was prepared in the same manner as Example 1 as the first circuit member. Next, a glass panel was prepared comprising the same type of Al circuit electrode as for Example 5, as a second circuit member. Pre-connection of the circuit-connecting material B and the main connection were carried out in the same manner as the connection in Example 6 to obtain a circuit connection structure for Example 10.

(Comparative Example 1)

An FPC was prepared in the same manner as Example 1 as the first circuit member. Next, a glass panel (thickness: 1.1 mm) was prepared comprising an ITO circuit electrode (thickness: 25 nm, surface resistance: <40 Ω) on the surface, as a second circuit member. The circuit of the second circuit member had a line width of 25 μm and a pitch of 50 μm. Pre-connection of the circuit-connecting material A and the main connection were carried out in the same manner as the connection in Example 1, to obtain a circuit connection structure for Comparative Example 1.

(Comparative Example 2)

An FPC was prepared in the same manner as Example 1 as the first circuit member. Next, a glass panel was

prepared comprising the same type of ITO circuit electrode as for Comparative Example 1 (thickness: 25 nm), as a second circuit member. Pre-connection of the circuit-connecting material B and the main connection were carried out in the same manner as the connection in Example 6, to obtain a circuit connection structure for Comparative Example 2.

(Comparative Example 3)

An FPC was prepared in the same manner as Example 1 as the first circuit member. Next, a glass panel was prepared comprising the same type of ITO circuit electrode as for Example 1 (thickness: 50 nm), as a second circuit member. Pre-connection of the circuit-connecting material C and the main connection were carried out in the same manner as the connection in Example 1, to obtain a circuit connection structure for Comparative Example 3.

(Comparative Example 4)

An FPC was prepared in the same manner as Example 1 as the first circuit member. Next, a glass panel was prepared comprising the same type of IZO circuit electrode as for Example 2, as a second circuit member. Pre-connection of the circuit-connecting material C and the main connection were carried out in the same manner as the connection in Example 1, to obtain a circuit connection structure for Comparative Example 4.

(Comparative Example 5)

An FPC was prepared in the same manner as Example 1 as the first circuit member. Next, a glass panel was prepared comprising the same type of ITO/Cr circuit electrode as for Example 3, as a second circuit member. Pre-connection of the circuit-connecting material C and the main connection were carried out in the same manner as the connection in Example 1, to obtain a circuit connection structure for Comparative Example 5.

(Comparative Example 6)

An FPC was prepared in the same manner as Example 1 as the first circuit member. Next, a glass panel was prepared comprising the same type of ITO/Ti/Al/Ti circuit electrode as for Example 4, as a second circuit member. Pre-connection of the circuit-connecting material C and the main connection were carried out in the same manner as the connection in Example 1, to obtain a circuit connection structure for Comparative Example 6.

(Comparative Example 7)

An FPC was prepared in the same manner as Example 1 as the first circuit member. Next, a glass panel was prepared comprising the same type of ITO circuit electrode as for Comparative Example 1 (thickness: 25 nm), as a second circuit member. Pre-connection of the circuit-connecting material C and the main connection were carried out in the same manner as the connection in Example 1, to obtain a circuit connection structure for Comparative Example 7.

(Comparative Example 8)

An FPC was prepared in the same manner as Example 1 as the first circuit member. Next, a glass panel was prepared comprising the same type of Al circuit electrode as for Example 5, as a second circuit member. Pre-connection of the circuit-connecting material C and the main connection were carried out in the same manner as the connection in Example 1, to obtain a circuit connection structure for Comparative Example 8.

(Comparative Example 9)

An FPC was prepared in the same manner as Example 1 as the first circuit member. Next, a glass panel was prepared comprising the same type of ITO circuit electrode as for Example 1 (thickness: 50 nm), as a second circuit member. Pre-connection of the circuit-connecting material D and the main connection were carried out in the same manner as the connection in Example 1, to obtain a circuit connection structure for Comparative Example 9.

(Comparative Example 10)

An FPC was prepared in the same manner as Example 1 as the first circuit member. Next, a glass panel was prepared comprising the same type of IZO circuit electrode as for Example 2, as a second circuit member. Pre-connection of the circuit-connecting material D and the main connection were carried out in the same manner as the connection in

Example 1, to obtain a circuit connection structure for Comparative Example 10.

(Comparative Example 11)

An FPC was prepared in the same manner as Example 1 as the first circuit member. Next, a glass panel was prepared comprising the same type of ITO/Cr circuit electrode as for Example 3, as a second circuit member. Pre-connection of the circuit-connecting material D and the main connection were carried out in the same manner as the connection in Example 1, to obtain a circuit connection structure for Comparative Example 11.

(Comparative Example 12)

An FPC was prepared in the same manner as Example 1 as the first circuit member. Next, a glass panel was prepared comprising the same type of ITO/Ti/Al/Ti circuit electrode as for Example 4, as a second circuit member. Pre-connection of the circuit-connecting material D and the main connection were carried out in the same manner as the connection in Example 1, to obtain a circuit connection structure for Comparative Example 12.

(Comparative Example 13)

An FPC was prepared in the same manner as Example 1 as the first circuit member. Next, a glass panel was prepared comprising the same type of ITO circuit electrode as for Comparative Example 1 (thickness: 25 nm), as a second circuit member. Pre-connection of the circuit-connecting material D and the main connection were carried out in the same manner as the connection in Example 1, to obtain a circuit connection structure for Comparative Example 13.

(Comparative Example 14)

An FPC was prepared in the same manner as Example 1 as the first circuit member. Next, a glass panel was prepared comprising the same type of Al circuit electrode as for Example 5, as a second circuit member. Pre-connection of the circuit-connecting material D and the main connection were carried out in the same manner as the connection in Example 1 to obtain a circuit connection structure for Comparative Example 14.

(Comparative Example 15)

An FPC was prepared in the same manner as Example 1 as the first circuit member. Next, a glass panel was prepared comprising the same type of ITO circuit electrode as for Example 1 (thickness: 50 nm), as a second circuit member. Pre-connection of the circuit-connecting material E and the main connection were carried out in the same manner as the connection in Example 1, to obtain a circuit connection structure for Comparative Example 15.

(Comparative Example 16)

An FPC was prepared in the same manner as Example 1 as the first circuit member. Next, a glass panel was prepared comprising the same type of IZO circuit electrode as for Example 2, as a second circuit member. Pre-connection of the circuit-connecting material E and the main connection were carried out in the same manner as the connection in Example 1, to obtain a circuit connection structure for Comparative Example 16.

(Comparative Example 17)

An FPC was prepared in the same manner as Example 1 as the first circuit member. Next, a glass panel was prepared comprising the same type of ITO/Cr circuit electrode as for Example 3, as a second circuit member. Pre-connection of the circuit-connecting material E and the main connection were carried out in the same manner as the connection in Example 1, to obtain a circuit connection structure for Comparative Example 17.

(Comparative Example 18)

An FPC was prepared in the same manner as Example 1 as the first circuit member. Next, a glass panel was prepared comprising the same type of ITO/Ti/Al/Ti circuit electrode as for Example 4, as a second circuit member. Pre-connection of the circuit-connecting material E and the main connection were carried out in the same manner as the connection in Example 1, to obtain a circuit connection structure for Comparative Example 18.

(Comparative Example 19)

An FPC was prepared in the same manner as Example 1 as the first circuit member. Next, a glass panel was prepared comprising the same type of ITO circuit electrode as for Comparative Example 1 (thickness: 25 nm), as a second circuit member. Pre-connection of the circuit-connecting material E and the main connection were carried out in the same manner as the connection in Example 1, to obtain a circuit connection structure for Comparative Example 19.

(Number of conductive particles on circuit electrode)

A differential interference microscope was used for visual count of the number of conductive particles on each circuit electrode of the circuit connection structure (n = 38). As a result, the average number of particles on the circuit electrodes of Examples 1-15 and Comparative Examples 1-15 was in the range of 31-38, and no major change in the number of conductive particles was found with different circuit-connecting materials or connecting members.

(Measurement of connection resistance)

For each of the circuit connection structures of Examples 1-10 and Comparative Examples 1-15 obtained in the manner described above, the connection resistance values between the circuit electrode of the FPC and the circuit electrode of the second circuit member were measured using a multimeter. The connection resistance values were measured initially (immediately after connection) and after standing for 250 hours in a high-temperature, high-humidity bath at 80°C, 95% RH (high-temperature, high-humidity treatment). The measurement results and resistance variations for the connection resistance values are shown in Table 2. In Table 2, the connection resistance values are expressed as the sum of the average value x and three times the standard deviation σ (3σ) for 37 resistance points between the adjacent circuits (x+3σ). The increase in resistance is expressed as the percentage increase of the resistance value after high-temperature, high-humidity treatment from the initial resistance value, and specifically it was calculated by the following formula:

$$((\text{Resistance value after treatment} - \text{initial resistance value})/\text{initial resistance value}) \times 100$$

The improving effect on connection reliability was judged as follows: less than 10% increase in resistance was judged as an improving effect, at least 10% and less than 15% was judged as prior art level, and 15% or greater was judged as no improving effect.

[Table 2]

| Example/ Comp. Ex. | Circuit connecting material | Adhesive composition | Conductive particles | | | First circuit electrode thickness | Second circuit electrode | | Connection resistance (Ω) | | Increase in resistance (%) |
|---|---|---|---|---|---|---|---|---|---|---|---|
| | | | No. | Bumps | Outermost layer | | Configuration | Thickness (nm) | Initial | After treatment | |
| Example 1 | A | Epoxy | 2 | + | Ni | 8 µm | ITO circuit | 50 | 118.3 | 122.6 | 3.6 |
| Example 2 | | | | | | | IZO circuit | 50 | 85.1 | 88.7 | 4.2 |
| Example 3 | | | | | | | ITO/Cr circuit | 250 | 67.3 | 71.1 | 5.6 |
| Example 4 | | | | | | | ITO/Ti/Al/Ti circuit | 452 | 65.0 | 68.2 | 4.9 |
| Example 5 | | | | | | | Al circuit | 200 | 23.1 | 23.9 | 3.5 |
| Example 6 | B | Acryl | 2 | + | Ni | 8 µm | ITO circuit | 50 | 121.6 | 126.3 | 3.9 |
| Example 7 | | | | | | | IZO circuit | 50 | 88.4 | 92.5 | 4.6 |
| Example 8 | | | | | | | ITO/Cr circuit | 250 | 66.5 | 69.1 | 3.9 |
| Example 9 | | | | | | | ITO/Ti/Al/ Ti circuit | 450 | 67.8 | 70.9 | 4.6 |
| Example 10 | | | | | | | Al circuit | 200 | 23.3 | 24.1 | 3.4 |
| Comp. Ex. 1 | A | Epoxy | 2 | + | Ni | 8 µm | ITO circuit | 25 | 185.2 | 203.8 | 10.0 |
| Comp. Ex. 2 | B | Acryl | 2 | + | Ni | 8 µm | ITO circuit | 25 | 189.0 | 206.9 | 9.5 |

(continued)

| Example/ Comp. Ex. | Circuit connecting material | Adhesive composition | Conductive particles | | | First circuit electrode thickness | Second circuit electrode | | Connection resistance (Ω) | | Increase in resistance (%) |
|---|---|---|---|---|---|---|---|---|---|---|---|
| | | | No. | Bumps | Outermost layer | | Configuration | Thickness (nm) | Initial | After treatment | |
| Comp. Ex. 3 | C | Epoxy | 1 | - | Ni | 8 μm | ITO circuit | 50 | 126.3 | 152.6 | 20.8 |
| Comp. Ex. 4 | | | | | | | IZO circuit | 50 | 92.6 | 115.5 | 24.7 |
| Comp. Ex. 5 | | | | | | | ITO/Cr circuit | 250 | 75.1 | 92.3 | 22.9 |
| Comp. Ex. 6 | | | | | | | ITO/Ti/Al/ Ti circuit | 450 | 71.1 | 94.2 | 32.5 |
| Comp. Ex. 7 | | | | | | | ITO circuit | 25 | 193.8 | 244.4 | 26.1 |
| Comp. Ex. 8 | | | | | | | Al circuit | 200 | 26.0 | 32.7 | 25.8 |
| Comp. Ex. 9 | D | Epoxy | 3 | - | Au | 8 μm | ITO circuit | 50 | 121.7 | 140.8 | 15.7 |
| Comp. Ex. 10 | | | | | | | IZO circuit | 50 | 86.4 | 103.3 | 19.6 |
| Comp. Ex. 11 | | | | | | | ITO/Cr circuit | 250 | 73.4 | 83.4 | 13.6 |
| Comp. Ex. 12 | | | | | | | ITO/Ti/Al Ti circuit | 450 | 66.8 | 81.1 | 21.4 |
| Comp. Ex. 13 | | | | | | | ITO circuit | 25 | 188.6 | 208.9 | 10.8 |
| Comp. Ex. 14 | | | | | | | Al circuit | 200 | 23.9 | 28.5 | 19.2 |

(continued)

| Example/ Comp. Ex. | Circuit connecting material | Adhesive composition | Conductive particles | | | First circuit electrode thickness | Second circuit electrode | | Connection resistance (Ω) | | Increase in resistance (%) |
|---|---|---|---|---|---|---|---|---|---|---|---|
| | | | No. | Bumps | Outermost layer | | Configuration | Thickness (nm) | Initial | After treatment | |
| Comp. Ex. 15 | E | Epoxy | 4 | + | Au | 8 μm | ITO circuit | 50 | 118.7 | 135.2 | 13.9 |
| Comp. Ex. 16 | | | | | | | IZO circuit | 50 | 85.8 | 99.4 | 15.9 |
| Comp. Ex. 17 | | | | | | | ITO/Cr circuit | 250 | 70.4 | 82.2 | 16.8 |
| Comp. Ex. 18 | | | | | | | ITO/Ti/Al/Ti circuit | 450 | 66.3 | 77.3 | 16.5 |
| Comp. Ex. 19 | | | | | | | ITO circuit | 25 | 185.9 | 205.7 | 10.7 |

Based on the results in Table 2, when connection was established using a circuit-connecting material containing conductive particles with protrusions and with nickel as the outermost layer, regardless of the type of adhesive composition composing the circuit-connecting material, the circuit connection structures with first and second circuit electrode thicknesses both of 50 nm or greater (Examples 1-10) produced lower values for the initial resistance value and for the increase in resistance after high-temperature, high-humidity treatment, and thus improved connection reliability, compared to structures wherein the second circuit electrode thickness was less than 50 nm (Comparative Examples 1 and 2).

The circuit connection structures wherein connection was established using a circuit-connecting material containing conductive particles with protrusions (Examples 1-10) had reduced initial resistance values and increase in resistance after high-temperature, high-humidity treatment, and therefore improved connection reliability, compared to the structures employing conductive particles without protrusions (Comparative Examples 3-14).

Furthermore, the circuit connection structures wherein connection was established using a circuit-connecting material containing conductive particles with nickel as the outermost layer (Examples 1-5) had reduced initial resistance values and increase in resistance after high-temperature, high-humidity treatment, and therefore improved connection reliability, compared to the structures employing conductive particles with Au as the outermost layer (Comparative Examples 15-19).

The data in Table 2 demonstrate that a circuit connection structure wherein the first and second circuit electrode thicknesses are both at least 50 nm and connection is established using a circuit-connecting material containing conductive particles with protrusions and with nickel as the outermost layer has an effect of lowering the initial resistance value and increase in resistance, and can therefore provide satisfactory electrical connection and long-term reliability of electrical characteristics compared to a circuit connection structure wherein connection is established using a circuit-connecting material that does not satisfy these conditions.

The results described above confirmed that the circuit connection structure of the invention can provide satisfactory electrical connection between opposing circuit electrodes as well as sufficiently increased long-term reliability of electrical characteristics between circuit electrodes.

## Industrial Applicability

The circuit connection structure of the invention can provide satisfactory electrical connection between opposing circuit electrodes as well as sufficiently increased long-term reliability of electrical characteristics between circuit electrodes.

## Claims

1. A circuit connection structure comprising
a first circuit member having a first circuit electrode formed on the main side of a first circuit board,
a second circuit member situated opposing the first circuit member and having a second circuit electrode formed on the main side of a second circuit board, and
a circuit-connecting member provided between the main side of the first circuit member and the main side of the second circuit member and electrically connecting the first and second circuit electrodes,
**characterized in that** the thickness of the first and second circuit electrodes is at least 50 nm, the circuit-connecting member is obtained by curing a circuit-connecting material containing an adhesive composition and conductive particles having multiple protrusions on the surface side, and the outermost layer of the conductive particles is composed of nickel or a nickel alloy.

2. A circuit connection structure according to claim 1, **characterized in that** at least the outermost layer of the first or second circuit electrode contains indium-tin oxide.

3. A circuit connection structure according to claim 1, **characterized in that** at least the outermost layer of the first or second circuit electrode contains indium-zinc oxide.

4. A circuit connection structure according to any one of claims 1 to 3, **characterized in that** the heights of the protrusions of the conductive particles are 50-500 nm and the distance between adjacent protrusions is no greater than 1000 nm.

5. A circuit-connecting material for electrical connection between opposing circuit electrodes, **characterized by** containing an adhesive composition and conductive particles comprising multiple protrusions on the surface side, wherein the outermost layer of the conductive particles is composed of nickel or a nickel alloy.

Fig.1

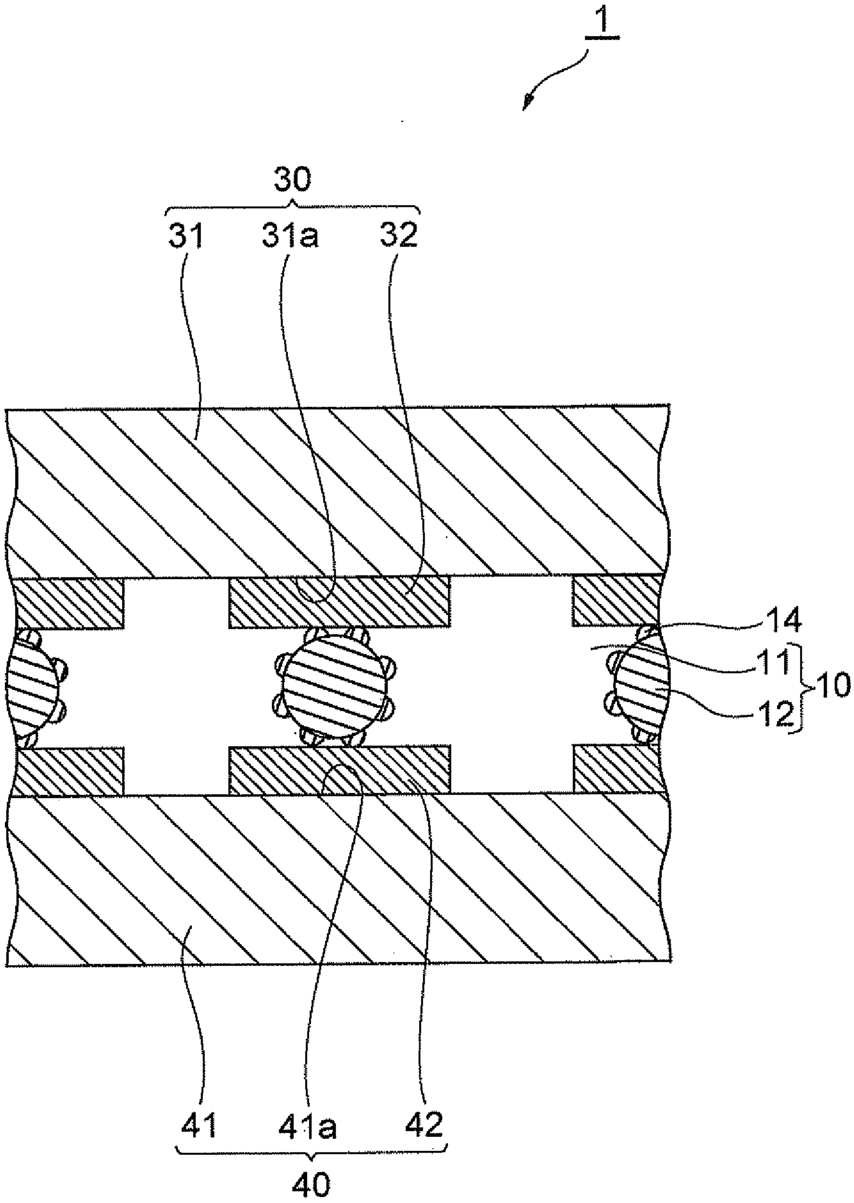

# Fig.2

(a)

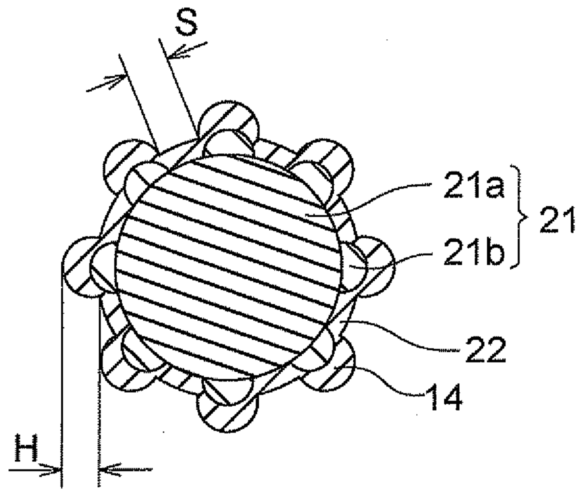


(b)

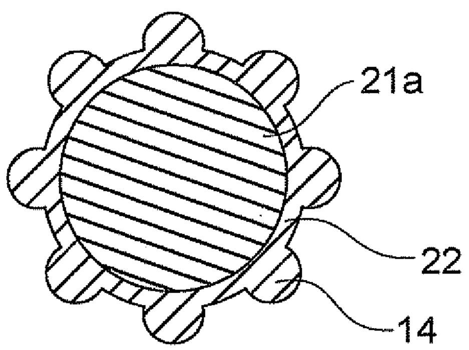

**INTERNATIONAL SEARCH REPORT**

International application No.
PCT/JP2007/071090

A. CLASSIFICATION OF SUBJECT MATTER
*H01L21/60*(2006.01)i, *H01B1/00*(2006.01)i, *H01B1/22*(2006.01)i, *H01B5/16*(2006.01)i, *H05K1/14*(2006.01)i

According to International Patent Classification (IPC) or to both national classification and IPC

B. FIELDS SEARCHED

Minimum documentation searched (classification system followed by classification symbols)
H01L21/60, H01B1/00, H01B1/22, H01B5/16, H05K1/14

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2007 |
| Kokai Jitsuyo Shinan Koho | 1971-2007 | Toroku Jitsuyo Shinan Koho | 1994-2007 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2005-166438 A (Hitachi Chemical Co., Ltd.), 23 June, 2005 (23.06.05), Full text; Figs. 1 to 3 (Family: none) | 1-4 |
| | JP 2002-324427 A (Toppan Forms Co., Ltd.), 08 November, 2002 (08.11.02), | |
| X | Full text; Figs. 1 to 3 | 5 |
| Y | Full text; Figs. 1 to 3 (Family: none) | 1-4 |
| | JP 2006-228474 A (Sekisui Chemical Co., Ltd.), 31 August, 2006 (31.08.06), | |
| X | Full text; Figs. 1 to 2 | 5 |
| Y | Full text; Figs. 1 to 2 (Family: none) | 1-4 |

☒ Further documents are listed in the continuation of Box C.  ☐ See patent family annex.

* Special categories of cited documents:
- "A" document defining the general state of the art which is not considered to be of particular relevance
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| | |
|---|---|
| Date of the actual completion of the international search<br>22 November, 2007 (22.11.07) | Date of mailing of the international search report<br>04 December, 2007 (04.12.07) |
| Name and mailing address of the ISA/<br>Japanese Patent Office<br>Facsimile No. | Authorized officer<br><br>Telephone No. |

Form PCT/ISA/210 (second sheet) (April 2007)

**INTERNATIONAL SEARCH REPORT**

International application No.
PCT/JP2007/071090

C (Continuation). DOCUMENTS CONSIDERED TO BE RELEVANT

| Category* | Citation of document, with indication, where appropriate, of the relevant passages | Relevant to claim No. |
|---|---|---|
| | JP 2000-171823 A (Casio Computer Co., Ltd.), 23 June, 2000 (23.06.00), | |
| X | Full text; Figs. 1 to 7 | 5 |
| Y | Full text; Figs. 1 to 7 (Family: none) | 1-4 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 59120436 A
- JP 60191228 A
- JP 1251787 A
- JP 7090237 A
- JP 2001189171 A
- JP 2005166438 A


### Non-patent literature cited in the description


- **Mochizuki et al.** *Hyoumen Gijutsu,* 1997, vol. 48 (4), 429-432
- **Ogiwara et al.** *Amorphous Platings,* 1994, vol. 36, 35-37
- **Ogiwara et al.** *Institute of Circuit Mounting,* 1995, vol. 10 (3), 148-152